(19) Europäisches Patentamt

European Patent Office

Office européen des brevets

(11) Veröffentlichungsnummer : **0 287 771 B1**

(12) # EUROPÄISCHE PATENTSCHRIFT

(45) Veröffentlichungstag der Patentschrift :
**15.05.91 Patentblatt 91/20**

(51) Int. Cl.⁵ : **H01T 1/00,** H01T 15/00,
H03K 3/537

(21) Anmeldenummer : **88102496.2**

(22) Anmeldetag : **20.02.88**

(54) **EMP - Generator.**

(30) Priorität : **02.03.87 CH 774/87**

(43) Veröffentlichungstag der Anmeldung :
**26.10.88 Patentblatt 88/43**

(45) Bekanntmachung des Hinweises auf die
Patenterteilung :
**15.05.91 Patentblatt 91/20**

(84) Benannte Vertragsstaaten :
**CH DE FR GB LI SE**

(56) Entgegenhaltungen :
**FR-A- 2 184 187**
**US-A- 3 496 378**
**US-A- 3 832 569**
**US-A- 3 867 663**

(56) Entgegenhaltungen :
**IEEE TRANSACTIONS OF ANTENNAS AND
PROPAGATIONS, Band AP-26, Nr. 1, Januar
1978, Seiten 53-59, IEEE; I.D. SMITH et al.:
"Pulsed power for EMP simulators"**

(73) Patentinhaber : **BBC Brown Boveri AG
Haselstrasse
CH-5401 Baden (CH)**

(72) Erfinder : **Garbe, Heyno, Dr.
Im Rüteli 11
CH-5401 Baden (CH)**
Erfinder : **Hansen, Diethard, Dr.
Bahnhofstrasse 39a
CH-8965 Berikon (CH)**
Erfinder : **Königstein, Dietrich, Dr.
Oberriedenstrasse 61
CH-5412 Gebenstorf (CH)**

## Beschreibung

Die vorliegende Erfindung betrifft einen EMP-Generator gemäss dem Oberbegriff des Anspruchs 1. Die Abkürzung EMP steht für "Elektro-Magnetischer-Puls". Der EMP-Generator soll zur EMP-Simulation durch Stromeinspritzung dienen.

Aus der Französischen Patentschrift 2.184.187 ist eine Funkenstrecke bekannt, die bedingt für einen EMP-Generator eingesetzt werden könnte. Diese Funkenstrecke weist zwei in einem Gehäuse angeordnete Pole auf, die halbkugelförmig ausgebildet sind. Ein Innenraum des Gehäuses kann mittels einer angeschlossenen Druckluftleitung unter Überdruck gesetzt werden. Mittels einer zweiten Druckluftleitung kann dieser Überdruck wieder abgebaut werden. Einer der Pole ist beweglich ausgebildet, wobei ein mit diesem Pol verbundener Faltenbalg abdichtend zwischen Innenraum und umgebender Atosphäre wirkt. Der bewegliche Pol wird mittels der Kraft einer Feder gegen den Überdruck im Innenraum in Position gehalten. Diese Funkenstrecke kann bei konstanter angelegter Spannung nur mittels eines Abbaus des Überdrucks im Innenraum zum Durchzünden gebracht werden, wobei wegen der Druckreduzierung und gleichzeitig wegen des sich nach innen bewegenden beweglichen Poles die Durchschlagsfestigkeit der Funkenstrecke abnimmt bis zum Durchzünden. Unabhängig vom Überdruck im Innenraum kann der bewegliche Pol nicht betätigt werden.

Die Suche nach realitätsnahen, kostengünstigen EMP-Simmulationsmethoden beschäftigt zunehmend Normengremien, EMP-verantwortliche Regierungsstellen und vor allem die Industrie als Geräte- und Anlagelieferant.

Bei der EMP-Simulation geht es darum, die Auswirkungen elektromagnetischer Störfelder, insbesondere des sogenannten NEMP, auf elektrische oder elektronische Systeme zu untersuchen, geeignete Schutzmassnahmen zu ergreifen und diese auf ihre Wirksamkeit hin zu überprüfen. Der NEMP ist ein bei der Explosion einer Atombombe ausserhalb der Erdatmosphäre zu erwartender elektromagnetischer Puls von einigen wenigen Nanosekunden Anstiegszeit, einer Abklinghalbwertzeit von ca. 200 Nanosekunden und einer Feldstärke von ca 50 kV/m.

Die zu untersuchenden Systeme unmittelbar einer Feldbestrahlung auszusetzen, ist häufig zu aufwendig und vor allem bei grösseren Geräten und insbesondere bei Anlagen oft gar nicht möglich.

Eine Alternative bietet hier die bereits genannte Stromeinspritzungstechnik, denn die von den Feldern verursachten Ströme in den Systemen sind letztlich die Ursache für deren Störung oder Zerstörung.

Bei der Stromeinspritzungstechnik wird das zu untersuchende System direkt mit einem von einem Generator erzeugten Strom beaufschlagt. Alternativ wird das System mit einer Spannung beaufschlagt, die gegebenenfalls einen Stromfluss zur Folge hat. In der Regel handelt es sich bei den zu untersuchenden Systemen um elektrische oder elektronische Geräte, die bereits mit einer Abschirmung versehen sind. In diesen Fällen wird der Strom einfach über eine der meist vorhandenen Steckverbindungen am Abschirmgehäuse eingespeist. Eine Normvorschrift der US-Navy MIL STD 461C schreibt für diese Art der Prüfung einen Generator vor, der an einer ohm'schen Last einen mit einer Frequenz zwischen 10 kHz und 100 MHz schwingenden Strom- oder Spannungspuls von 10A bzw. 1kV erzeugt. Durch die Norm soll sichergestellt werden, dass die Systemprüfung unter Bedingungen erfolgt, wie sie im Falle eines NEMP erwartet werden.

Tatsächlich haben Messungen in EMP-Feldsimmulatoren Strom- bzw. Spannungsformen und Stärken der oben genannten Art in elektrischen oder elektronischen Systemen bei Bestrahlung mit einem dem NEMP entsprechenden Puls ergeben. Dennoch weist das normierte Testverfahren schwerwiegende Nachteile und nicht unerhebliche Risiken auf.

Das Hauptproblem besteht darin, dass die nach der Norm zu verwendenden Generatoren den vorgeschriebenen Puls nur an einem 100 kΩ-Widerstand erzeugen, dass jedoch in Verbindung mit dem zu testenden System als Last ganz andere Pulsformen entstehen können. Eine Anpassung des Generators an die jeweilige Last, d.h. an die jeweiligen Eigenschaften des jeweils zu testenden Systems, ist nicht vorgesehen.

Es sind auch keine Generatoren bekannt, bei denen eine solche Anpassung ohne weiteres durchführbar wäre. Eine solche Anpassung ist zum Erhalt eines auch nur einigermassen sinnvollen Test- und Prüfungsergebnisses jedoch unbedingt erforderlich.

Ein weiteres Problem ergibt sich durch die Einspritzung des Testpulses direkt in das System hinein. Bei abgeschirmten Systemen bewirken elektromagnetische Felder immer primär Ströme auf der Oberfläche der Abschirmung. Die innerhalb der Abschirmung auftretenden Spannungen und Ströme sind erst die sekundäre Folge dieser Oberflächenströme und werden durch Einkopplung bewirkt. Wie stark und von welcher Art die Einkopplungen sind, hängt von vielen Faktoren ab. Die typische Schirmdämpfung beträgt etwa 40 dB. In der Regel werden die Pulse nicht formgetreu übertragen. Die innerhalb der Abschirmung auftretenden Ströme und Spannungen weisen deshalb einen von den Strömen auf die Abschirmungen unterschiedlichen Verlauf auf.

Vom zeitlichen Verlauf der eingekoppelten Ströme und Spannungen hängt aber wesentlich deren Wirkung auf das System ab. So wird beispielsweise das Auftreten von Durchschlägen oder das Ansprechen von Schutzelementen wie z.B. Funkenstrecken von der Steilheit der Pulse beeinflusst. Ob und wann ein Durchschlag auftritt oder ein Schutzelement anspricht sind natürlich entscheidende Kriterien für das Verhalten eines Systems unter Störbelastung. Indem der Strom- oder Spannungspuls direkt in das Innere des zu untersuchenden Systems eingespritzt wird, werden alle Effekte, die mit der Einkopplung von seiner Abschirmung aus auftreten, messtechnisch vernachlässigt.

Neben einer Anpassung des Generators und der von ihm erzeugten Strom- oder Spannungspulse an das jeweils zu untersuchende System sollte daher deren Applikation nicht im Inneren des Systems sondern auf dessen Abschirmung erfolgen. Ein weiterer wichtiger Grund dafür ist, dass die auf den Abschirmungen durch die elektromagnetischen Störfelder auftretenden Oberflächenströme durch Rechnung noch relativ gut vorhersagbar sind, deren Einkopplungsverhalten in das System jedoch nicht.

Die Applikation der Strom- oder Spannungspulse auf der Abschirmung hat natürlich zur Folge, dass um das Dämpfungsmass von ca. 40 dB höhere Stromstärken bzw. Spannungen vom Generator erzeugt und geliefert werden müssen.

Bekannte Generatoren, die den vorgenannten Anforderungen prinzipiell genügen, sind sehr grosse, unhandliche, praktisch nicht transportable und teure Geräte.

Ein weiteres Problem bei den bekannten Generatoren ist, dass sie entweder einen Strompuls oder einen Spannungspuls liefern. Bei der Störeinkopplung in ein System treten aber häufig Spannungen und Strom nacheinander auf. Zuerst baut sich eine Spannung auf. Ueberschreitet diese ein bestimmtes (von der Steilheit des Spannungsanstieges abhängiges) Niveau, so kommt es beispielsweise zu einem Durchschlag und ein Stromfluss ist die Folge. Das zu untersuchende System schaltet also selbsttätig von einem Spannungspuls auf einen Strompuls um. Der für die Systemprüfung eingesetzte Generator sollte auch dafür ausgebildet sein.

Die Erfindung, wie sie in den Ansprüchen 1 und 4 definiert ist, löst u.a. die Aufgabe, einen EMP-Generator anzugeben, der im Rahmen des vorstehend erläuterten Mess- und Prüfkonzeptes einsetzbar ist und den aus diesem Konzept resultierenden Anforderungen genügt.

Vorteilhafte Ausgestaltungen der Erfindung sind in den abhängigen Patentansprüchen gekennzeichnet.

Weitere Merkmale sowie die Vorteile der vorliegenden Erfindung ergeben sich aus der nachstehenden ausführlichen Beschreibung von Ausführungsbeispielen, insbesondere unter Berücksichtigung der beigefügten Zeichnungen. Es zeigen :

Fig. 1 in schematischer Darstellung einen EMP-Generator mit angeschlossener Last und einer pneumatisch steuerbaren Funkenstrecke ;

Fig. 2 in geschnittener Darstellung sowie im Detail die Funkenstrecke gemäss Fig. 1 ;

Fig. 3 ein Schaltbild einer besonders vorteilhaften Generatorschaltung mit zwei Funkenstrecken ;

Fig. 4 ein dem Schaltbild von Fig. 3 entsprechendes Schaltbild, jedoch in einem transienten Zustand nach Durchbruch einer der Funkenstrecken ;

Fig. 5 ein dem Schaltbild von Fig. 3 entsprechendes Schaltbild, jedoch in einem Zustand nach Durchbruch beider Funkenstrecken ;

Fig. 6 in schematischer Darstellung eine vorteilhafte räumliche Anordnung der Funkenstrecken und Kondensatoren der Schaltung von Fig. 3 zur Implementierung eines schnellen Hochleistungspulsgenerators ; und

Fig. 7 in schematischer Darstellung eine vorteilhafte räumliche Anordnung der Funkenstrecken einerseits und Kondensatoren der Schaltung von Fig. 3 zur Implementierung eines besonders leistungsfähigen Generators mit grossen Kapazitäten andererseits.

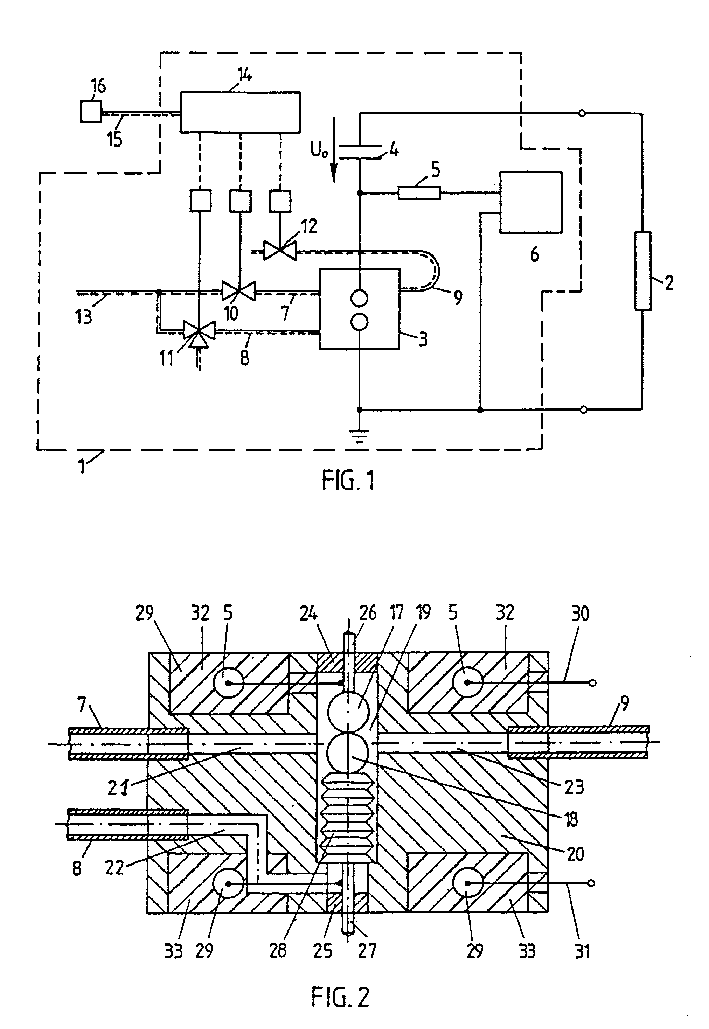

Es wird nunmehr auf die Zeichnungen Bezug genommen. Fig. 1 zeigt einen EMP-Generator mit angeschlossener Last 2. Der Generator selbst besteht hier einfach aus einer Reihenschaltung einer Funkenstrecke 3 und einem Kondensator 4. Die Last 2 ist an die Klemmen dieser Reihenschaltung angeschlossen. Der Kondensator 4 ist bei nichtleitender Funkenstrecke 3 über einen zwischen der Funkenstrecke 3 und ihm selbst an die Reihenschaltung angeschlossenen Vorwiderstand 5 auf eine Spannung Uo aufladbar, welche von einem Netzgerät 6 geliefert wird. Das Netzgerät 6 ist von der Art, dass es im Falle eines Kurzschlusses zwischen seinen Klemmen einen auf einen geringen Wert von wenigen mA begrenzten Kurzschlussstrom liefert. Die Funkenstrecke 2 ist eine pneumatisch auslösbare Funkenstrecke. An sie sind drei Druckluftleitungen 7,8 und 9 angeschlossen. Die Druckluftleitung 7 steht über ein steuerbares Ventil mit einer Druckluftleitung 13 in Verbindung. Ebenfalls mit der Druckluftleitung 13 steht die Druckluftleitung 8 über ein steuerbares Ventil 11 in Verbindung. Das Ventil 11 ist als Wechselventil ausgebildet, über das die Druckluftleitung 8 nach aussen entlastbar ist. Die Druckluftleitung 9 ist gegenüber der Umgebung mittels eines steuerbaren Ventils 12 verschliessbar.

Für die Steuerung der Ventile 10, 11 und 12 ist eine hydraulische Ablaufsteuerung 14 vorgesehen. Diese erhält ihr Startsignal über eine Schlauchleitung 15, an deren Ende ein von Hand schliessbares Druckventil 16 angeschlossen ist.

Die konkrete Ausbildung der Funkenstrecke 3 gemäss der vorliegenden Erfindung ist Fig. 2 zu entnehmen. Danach weist die Funkenstrecke 3 zwei Pole 17 und 18 auf. Diese sind im Innenraum 19 eines Gehäuses 20 angeordnet. Das Gehäuse 20 besteht aus einem elektrisch isolierenden Material. Es weist drei Oeffnungen 21, 22 und 23 auf, an die die bereits genannten Druckluftleitungen 7, 8 und 9 angeschlossen sind. Die Oeffnungen 21 und 23 sind einander gegenüberliegend angeordnet und münden im Bereich zwischen den beiden Polen 17 und 18 in den Innenraum 19 des Gehäuses 20. Der Innenraum 19 wird durch zwei Verschlussteile 24 und 25 gasdicht und druckfest abgeschlossen. Durch die Verschlussteile 24 und 25 hindurch sind die beiden Pole 17 und 18 der Funkenstrecke mit ersten äusseren Anschlusskontakten 26 und 27 verbunden. Der Pol 18 ist an einem zum Innenraum 19 des Gehäuses 20 hin luftdicht und druckfest abgeschlossen, bezüglich seiner Länge elastisch verformbaren Faltenbalg 28 befestigt. Das Innere des Faltenbalges 28 ist zur Oeffnung 22 hin offen und steht über diese mit der Druckluftleitung 8 in Verbindung.

Die Pole 17 und 18 der Funkenstrecke sind weiter über jeweils eine Kette von Widerständen 5 bzw. 29 mit zweiten äusseren Anschlusskontakten 30 bzw. 31 verbunden. Die Widerstände 5 entsprechen funktionell dem Vorwiderstand 5 von Fig. 1 und sind deshalb entsprechend bezeichnet. Auf die Bedeutung der Widerstände 29 wird weiter unten noch eingegangen. Die beiden Widerstandsketten 5 bzw. 29 sind in Ausnehmungen 32 bzw. 33 des Gehäuses 20 in einem nichtleitenden Material fest vergossen eingebettet. In Fig. 2 sind nur jeweils zwei Widerstände der Widerstandskette 5 bzw. 29 geschnitten sichtbar. Die beiden Ketten erstrecken sich jeweils beispielsweise über einen halben Umfang des Gehäuses 20. Die Form des Gehäuses 20 sowie seines Innenraumes 19 und dadurch auch die Form des Faltenbalges 28 ist zylindrisch. Die Länge des Gehäuses 20 beträgt ca. 6 cm, sein Durchmesser beträgt 8 cm und der des Innenraumes 19 ca. 2 cm.

Bei übereinstimmendem Druck im Innenraum 19 des Gehäuses 20 und im Innenraum des Faltenbalges 28 sind die Pole 17 und 18 der Funkenstrecke in direktem Berührungskontakt miteinander.

Verwendet wird die beschriebene Funkenstrecke, beispielsweise in einer Anordnung gemäss Fig. 1, in folgender Weise :

Man geht aus von einem Zustand, in dem über die Ventile 11 und 12 die Druckluftleitungen 8 und 9 nach aussen offen sind und das Ventil 10 geschlossen ist, so dass die Druckluftleitung 7 nicht mit der Druckluftleitung 13 verbunden ist. Im Innenraum 19 des Gehäuses 20 sowie im Inneren des Faltenbalges 28 herrscht dann übereinstimmend Umgebungsdruck. Die beiden Pole 17 und 18 sind in Berührungskontakt miteinander, was für das Neztgerät einen Kurzschluss darstellt. Wie erläutert, liefert das Netzgerät 6 jedoch nur einen geringen Kurzschlussstrom.

Zur Erzeugung eines Pulses wird zunächst das Ventil 12 geschlossen und das Ventil 10 geöffnet. Ueber die Druckluftleitung 7 ergibt sich dann im Innenraum 19 des Gehäuses 20 ein Ueberdruck gegenüber dem Innern des Faltenbalges 28, wodurch dieser zusammengedrückt, d.h. bezüglich seiner Länge verkürzt wird. Dadurch öffnet sich die Funkenstrecke, wodurch die Kurzschlusssituation aufgehoben und der Kondensator 4 geladen wird. Das Mass der Oeffnung der Funkenstrecke, d.h. der gegenseitige Abstand der beiden Pole hängt ab von der Druckdifferenz im Innenraum 19 des Gehäuses 20 und im Innern des Faltenbalges 28. Diese Druckdifferenz ist über das Ventil 11 einstellbar, das vorzugsweise ein Dosierventil ist.

Zum Durchbruch der Funkenstrecke und damit zur Erzeugung eines Pulses kommt es, wenn ein bestimmtes kritisches Verhältnis der Feldstärke zwischen den Polen 17 und 18 zum Druck im Innenraum 19 des Gehäuses überschritten wird. Die Feldstärke zwischen den Polen 17 und 18 hängt ab von der zwischen ihnen anliegenden Spannung, ihrem gegenseitigen Abstand sowie, was insbesondere ihre räumliche Verteilung anbetrifft, von ihrer Form. Die vorgenannten Parameter bestimmen auch die Schnelligkeit des Durchbruches und damit die Anstiegszeit des erzeugten Pulses.

Ein Durchbruch der Funkenstrecke kann nach dem Vorstehenden durch eine Erhöhung der Spannung bei festem Polabstand und Absolutdruck, durch Verringerung des Absolutdruckes bei fester Spannung und bei festem Polabstand oder durch Verringerung des Polabstandes bei fester Spannung und festem Absolutdruck provoziert werden.

Vorzugsweise wird die Spannung des Netzgerätes 6 fest vorgegeben, z.B. zu 25kV, und der Durchbruch der Funkenstrecke auf eine der letztgenannten Methoden provoziert. Die Verringerung des Absolutdruckes zwischen den Polen 17 und 18 kann z.B. durch Oeffnen des Ventils 12 verursacht werden. Dabei wird sich der Abstand der Pole 17 und 18 auch etwas verringern.

Lässt man das Ventil 10 nach dem Oeffnen des Ventils 12 und des dadurch verursachten Durchschlages noch eine gewissen Zeit offen, so wird die Funkenstrecke in vorteilhafter Weise nach ihrem Durchbruch beblasen, wodurch die Funkenstrecke für eine nachfolgende Zündung besser konditioniert wird. Die Oeffnungen 21 und 23 in Gehäuse 20 sind deshalb im Bereich der Funkenstrecke einander gegenüberliegend angeordnet, wie bereits erwähnt.

Vorzugsweise wird der Durchschlag jedoch durch Verringerung des Abstandes zwischen den Polen 17 und 18 durch Erhöhung des Druckes in der Druckluftleitung 8 mittels des Ventils 11 provoziert. Von dem Beblasen der Funkenstrecke wird jedoch auch in diesem Fall in vorteilhafter Weise Gebrauch gemacht.

Wie vorstehend bereits erwähnt, wird durch den Wert der Spannung zwischen den Polen 17 und 18, den Absolutdruck im Innenraum 19 des Gehäuse 20 sowie durch den Polabstand die Schnelligkeit des Durchschlags der Funkenstrecke und damit die Anstiegszeit des erzeugten Pulses bestimmt. Der Durchschlag wird um so schneller und die Anstiegszeit um so kleiner, je höher die Spannung, je höher der Absolutdruck und je geringer der Polabstand bei Zündung ist. Für den Absolutdruck sollte mindestens ein Wert gewählt werden, wie er in heutigen Druckluftinstallationen in Gebäuden oder Anlagen üblich ist, d.h. ein Druck zwischen $5 \cdot 10^5$ und $10 \cdot 10^5$ Pa. Bei vorgegebener Spannung und vorgegebenem Absolutdruck wird der Zündungsabstand minimal, wenn die Form der Pole 17 und 18 derart ausgebildet ist, dass sich zumindest auf ihren einander zugewandten Seiten auf ihrer Oberfläche eine konstante Feldstärke einstellt. Die dazu konkret erforderliche Form kann eine Dissertation von Heiner Grönewald, Universität Hamburg 1982, mit dem Titel "Feldoptimierung von Hochspannungsbauteilen", insbesondere Seite 139, entnommen werden.

Die in Fig. 1 dargestellte Ablaufsteuerung sollte so beschaffen sein, dass sie eine der vorgenannten Zündungs- und Beblasungsmechanismen automatisch zu steuern gestattet und lediglich eines pneumatischen Startsignals über die Schlauchleitung 15 bedarf.

Dass hier einem pneumatischen Startsignal der Vorzug vor einem elektrischen Startsignal gegeben wird, ist dadurch begründet, dass über die Schlauchleitung 15, im Gegensatz zu einem elektrischen Kabel keine elektromagnetischen Störungen übertragen bzw. verursacht werden.

Ueberhaupt ist in der Anordnung gemäss Fig. 1 und mit einer Funkenstrecke gemäss Fig. 2 zur Auslösung eines Durchschlags kein elektrischer Schaltvorgang erforderlich. Sämtliche Steuerungsschritte sind pneumatisch. Der Ladevorgang des Kondensators 4 beginnt erst, wenn die Funkenstrecke pneumatisch aufgefahren wird. Solange die Funkenstrecke geschlossen ist, fliesst nun der geringe Kurzschlussstrom. Es kann sich keine Spannung aufbauen. Das ist immer dann der Fall, solange der Innenraum 19 des Gehäuses 20 nicht durch geeignete Steuerung der Ventile 10 und 12 unter Ueberdruck gesetzt wird oder wenn es zu einem Druckausfall kommt. Dies trägt wesentlich dazu bei, die Gefährdung der den Generator handhabenden Person zu verringern.

Die vorstehend beschriebene, gemäss der vorliegenden Erfindung ausgebildete Funkenstrecke mit ihrer pneumatischen Steuerung ist in vorteilhafter Weise geeignet, in einfacher Weise auch in andere Generatorschaltung integriert zu werden.

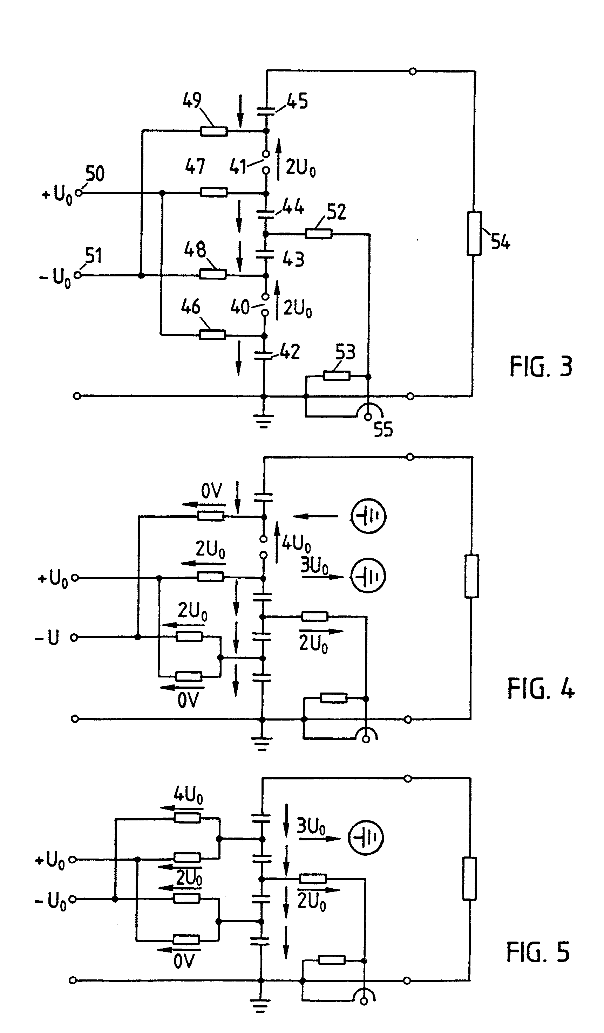

Eine mehrere besonders vorteilhafte Eigenschaften aufweisende, erfindungsgemässe Generatorenschaltung ist in Fig. 3 dargestellt. Bei dieser sind zwei Funkenstrecken 40 und 41 mit mehreren Kondensatoren 42-45 in Reihe geschaltet. In der Reihenschaltung sind ausgehend von einem auf Referenzpotential, z.B. Erdpotential, geschalteten Anschlusspunkt ein erster Kondensator 42, eine erste Funkenstrecke 40, ein zweiter Kondensator 43, in dritter Kondensator 44, die zweite Funkenstrecke 41 und ein vierter Kondensator 45 in der genannten Reihenfolge in Reihe geschaltet. An die Reihenschaltung ist über mehrere Widerstände 46-49 ein Netzgerät angeschlossen, von dem in Fig. 3 nun die Klemmen 50 und 51 dargestellt sind. Das Potential der Klemmen 50 und 51 ist symmetrisch zum Referenzpotential zu $\pm$ Uo gewählt, wobei Uo beispielsweise wieder 25 kV beträgt.

Die positive Klemme + Uo des Netzgeräts ist über den Widerstand 46 an einen Anschlusspunkt zwischen dem Kondensator 42 und der Funkenstrecke 40 und über den Widerstand 47 an einen Anschlusspunkt zwischen den Kondensator 44 und der Funkenstrecke 41 angeschlossen.

Die negative Klemme 51 des Netzgeräts ist über den Widerstand 48 an einen Anschlusspunkt zwischen der Funkenstrecke 40 und dem Kondensator 43 und über den Widerstand 49 an einen Anschlusspunkt zwischen der Funkenstrecke 41 und dem Kondenator 45 angeschlossen.

Ein Anschlusspunkt an der Reihenschaltung zwischen dem zweiten Kondensator 43 und dem dritten Kondensator 44 ist über einen Widerstand 52 sowie einen Widerstand 53 mit dem Referenzpotential verbunden.

Die Kapazität sämtlicher Kondensatoren 42-45 ist gleich gross gewählt. Der Wert des Widerstandes 52 (bzw. der Winderstände 52 und 53 zusammen) ist so gross gewählt, dass die durch die Kapazität eines Kondensators sowie durch diesen Widerstandswert bestimmte Zeitkonstante wesentlich grösser als die Entladezeitkonstante des Impulskreises (Kondensatoren 42-45, Widerstand 54, ggf. Lastinduktivität) ist (auf welche später noch eingegangen wird). Der genannte Widerstandswert beträgt beispielsweise 1 MΩ, wenn für den Widerstand 54 ein typischer Wert zwischen 50 Ω – 100 Ω angenommen wird.

An die Klemmen der Reihenschaltung von Fig. 3 ist schliesslich eine Last 54 angeschlossen.

Für die nachstehenden Erläuterungen der Funktion der Schaltung von Fig. 3 sei angenommen, dass die Funkenstrecken 40 und 41 von der Art sind, wie in Fig. 2 dargestellt und dass ein Netzgerät mit einem begrenzten Kurzschlussstrom verwendet wird. Die Widerstände 46 und 48 bzw. 47 und 49 in Fig. 3 werden dann durch die im Gehäuse 20 der Funkenstrecken nach Fig. 2 eingebetteten Widerstände bzw. Widerstandsketten 5 bzw. 29 gebildet. Selbstverständlich ist die Verwendung von Funkenstrecken gemäss Fig. 2 keine Notwendigkeit für die Funktion der Schaltung von Fig. 3. Auch anders ausgebildete Funkenstrecken könnten verwendet werden. Entsprechendes gilt für das Netzgerät.

Bevor die Funkenstrecken 40 und 41 unter Druck gesetzt werden, sind sie geschlossen. Das Netzgerät treibt über beide Funkenstrecken den Kurzschlussstrom.

Zur Erzeugung eines Pulses werden beide Funkenstrecken in der oben bereits beschriebenen Weise pneumatisch aufgefahren. Die Ladung der Kondensatoren 42 bis 45 ist die Folge. Durch die gewählte Schaltung liegt an den einzelnen Kondensatoren 42-45 jeweils nur eine Spannung an, die der Klemmenspannung Uo des Netzgerätes gegenüber dem Referenzpotential entspricht. An den Funkenstrecken 40 und 41 stellt sich jeweils eine doppelt so grosse Spannung ein.

Sind die Kondensatoren 42-45 geladen, so wird auf eine der oben beschriebenen Arten die Funkenstrecke 40 gezündet. Nach Zündung der Funkenstrecke 40 stellt sich die Spannung an der zweiten Funkenstrecke 41 auf den vierfachen Wert der Klemmenspannung Uo gegenüber dem Referenzpotential auf. Dieser transiente Zustand ist in Fig. 4 dargestellt. Fig. 4 zeigt eine mit Fig. 3 bis auf die fehlende Funkenstrecke 40 übereinstimmende Schaltung.

Durch die sich verdoppelnde Spannung bricht die zweite Funkenstrecke 41 ebenfalls durch, was zu einer Situation führt, wie sie in Fig. 5 dargestellt ist. Fig. 5 entspricht Fig. 4, nur dass hier auch noch die zweite Funkenstrecke 41 fehlt. Nach Zündung auch der zweiten Funkenstrecke 41 entladen sich die Kondensatoren über die Last 54.

In den Fig. 4 und 5 sind die Bezugszeichen an den einzelnen Elementen aus Gründen der Uebersichtlichkeit weggelassen.

Bezüglich des schnellen Vorgangs von der Zündung der ersten Funkenstrecke 40 bis zur Zündung der zweiten Funkenstrecke 41 (der zeitliche Abstand zwischen beiden Zündungen ist der Zündverzug der zweiten Funkenstrecke) muss die Reihenschaltung über die Widerstände 46-49 und 52 sowie 53 von ihrem Ladekreis, d.h. insbesondere dem Netzgerät, entkoppelt sein. Dazu sind die genannten Widerstände geeignet zu bemessen. Ein geeigneter Widerstandswert für die Widerstände 46-49 ist beispielsweise 100 kΩ. Für den Widerstand 52 wurde bereits ein Wert von 1 MΩ genannt. Bei dem Widerstandswert von 100 kΩ für die Widerstände 46-49 ist allerdings angenommen, dass diese Widerstände nicht gleichzeitig als Ladestrombegrenzungswiderstände dienen müssen, sondern dass die Begrenzung des Ladestroms wie auch des Kurzschlussstroms durch das Netzgerät gewährleistet wird. Der Wert des Widerstandes 53 kann Null sein ; wird er z.B. zu 1/1000 des Widerstandes 52 gewählt, ergibt sich an Punkt 55 ein Spannungsteilerausgang zur Ueberwachung der Pulsauslösung.

Der wesentliche Vorteil der beschriebenen Generatorschaltung gemäss Fig. 3 ist darin zu sehen, dass Spannungspulse mit einem Maximalwert erzeugt werden können, der dem vierfachen der Klemmenspannung des erforderlichen Netzgeräts gegenüber dem Referenzpotential entspricht. Zur Erzeugung eines 100 kV Spannungspulses ist daher lediglich ein Netzgerät erforderlich, welches ± 25 kV Spannung liefert. Solche Netzgeräte sind im Gegensatz zu 100 kV Netzgeräten klein und handlich, leicht transportabel, ohne grössere Sicherheitsvorkehrungen zu bedienen, sowie natürlich kostengünstiger. Desweiteren müssen die Kondensatoren und Widerstände der Schaltung nur für eine Dauerbelastung mit der einfachen Klemmenspannung Uo ausgelegt sein, obwohl an ihnen bis zu vierfach höhere Spannungswerte auftreten. Diese treten jedoch nur als Stossbelastungen auf, was für die Bauelemente erheblich weniger kritisch ist. Es können deshalb kleine und kostengünstige Bauelemente verwendet werden, was wiederum im Hinblick auf eine leichte und kompakte Bauweise des Generators von Vorteil ist. Welche Stossbelastungen an den Widerständen und Kondensatoren im einzelnen auftreten, ist den Fig. 4 und 5 entnehmbar. In diesen, wie auch in Fig. 3, sollen die nicht besonders bezeichneten Spannungspfeile jeweils die Klemmenspannung Uo des Netzgeräts gegenüber dem Referenzpotential angeben.

In der Generatorschaltung gemäss Fig. 3 bzw. den Fig. 4 und 5 ist jeweils noch ein Messpunkt 55 vorgesehen. Dieser ist durch den Widerstand 53 gegen das Referenzpotential entkoppelt. An diesem Messpunkt tritt bei Zündung der Funkenstrecke 40 ein Signal auf, welches als Triggersignal für eine in den Figuren nicht dargestelle Messelektronik verwendet werden kann. Die Ableitung eines solchen Signals ist deshalb wichtig, weil die Auslösung der Funkenstrecken pneumatisch erfolgt und der exakte Durchbruchszeitpunkt nicht vorhersehbar ist. Zusätzlich ist ein Referenzsensor für das E-Feld (56) im Bereich des Ausgangs des Pulsgenerators vorgesehen, der eine Eigenanstiegszeit deutlich unterhalb einer Nanosekunde besitzt.

Von besonderer Bedeutung für die Realisierung eines sehr schnellen Pulsgenerators mit gleichzeitig sehr hoher Leistung ist die Tatsache, dass in der Generatorschaltung gemäss Fig. 3 nur baulich kleine, lediglich für eine Dauerbelastung in Höhe der Klemmenspannung Uo des Netzgerätes gegenüber dem Referenzpotential ausgelegte Bauelemente verwendet werden müssen, denn im Bereich von Pulsanstiegszeiten im Bereich von ca. einer Nanosekunde spielt die Baugrösse im Hinblick auf Laufzeiteffekte sowie die Induktivität auch noch so kurzer Leitungsverbindungen bereits eine erhebliche Rolle.

Die genannte Tatsache der Verwendbarkeit kleiner kompakter Bauelemente, insbesondere kompakter Kondensatoren, in der Generatorschaltung nach Fig. 3 erlaubt es, in Verbindung mit Funkenstrecken, wie sie in Fig. 2 dargestellt sind, einen Generator zu realisieren, welcher einen 100 kV Puls mit einer Anstiegszeit von nur 1,5 Nanosekunden erzeugt.

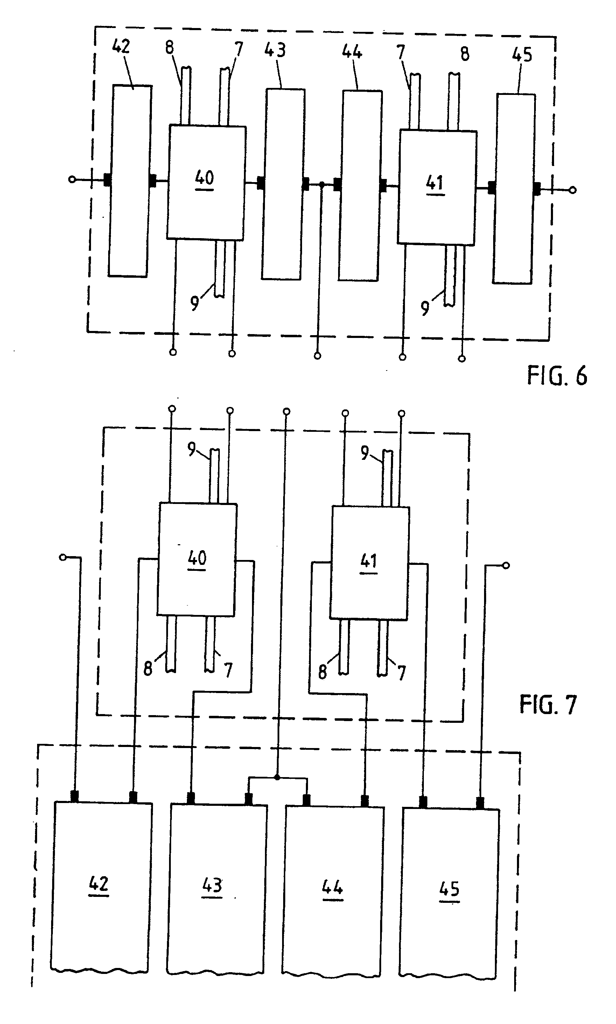

Ein solcher Generator ist in Fig. 6 schematisch dargestellt. 40 und 41 bezeichnen Funkenstrecken der Art von Fig. 2. 42-45 bezeichnen Scheibenkondensatoren. Die genannten Elemente bilden eine bauliche Einheit und sollen unmittelbar aufeinander aufgesteckt sein. Dazu ist es natürlich erforderlich, dass die Scheibenkondensatoren sowie die Funkenstrecken mit entsprechenden, zueinander passenden Steckverbindungskontakten versehen sind. Im Rahmen des Steckkonzepts lassen sich die Scheibenkondesatoren auch mit Vorteil gegen andere Scheibenkondensatoren mit unterschiedlicher Kapazität leicht austauschen. Dies ermöglicht die einfache Anpassung des Generators nach Fig. 6 an die Last 54 und die gewünschte Kurvenform des zu erzeugenden Pulses.

Reicht die mit Scheibenkondensatoren realisierbare Kapazität nicht aus für eine bestimmte Anwendung und müssen also z.B. grössere Blockkondensatoren verwendet werden, so kann eine Anordnung gewählt werden, die in Fig. 7 dargestellt ist. Hier bilden die beiden Funkenstrecken 40 und 41 eine bauliche Einheit, getrennt von den Kondensatoren 42-45. Vorzugsweise sind die Kondensatoren 42-45 ebenfalls zu einer baulichen Einheit zusammengefasst, auf die beispielsweise die Baueinheit mit den Funkenstrecken 40, 41 aufsteckbar ist. Durch Austausch der Kondensatoreinheit ist dann jeweils wieder in einfacher Weise eine Anpassung an die jeweilige Last möglich. Es versteht sich jedoch, dass mit der Anordnung nach Fig. 7 in der Regel keine so schnellen Pulse erzeugt werden können wie mit der Anordnung nach Fig. 6.

In allen obigen Generatorausführungen bildet das Netzgerät eine separate bauliche Einheit. Es muss daher über Kabel mit den Anschlusskontakten an den Funkenstrecken verbunden werden. Für das Netzgerät kann ein marktübliches Gerät verwendet werden.

Insgesamt wird durch die Erfindung ein ganzes modulares Generatorkonzept angegeben. Aus den Funkenstrecken, der ihnen zugehörigen Pneumatik sowie dem Netzgerät als feste Grundbausteine lassen sich, insbesondere im Rahmen der erfindungsgemässen Schaltung gemäss Fig. 3 mit unterschiedlichen Kondensatoren Generatoren aufbauen, die den vom jeweiligen Anwendungsfall vorgegebenen Anforderungen gerecht werden.

An dieser Stelle sei noch erwähnt, dass zusätzlich zu den in den Figuren 3 bis 7 dargestellten Schaltungselementen zur Erzeugung einer gewünschten Pulsform noch Induktivitäten erforderlich sein können, insbesondere zur Erzeugung von schwingenden Pulsen. Die erforderlichen Induktivitäten können jeweils mit den Kondensatoren in Reihe geschaltet werden.

Abschliessend sei noch auf die eingangs geforderte Eigenschaft des Generators eingegangen, eine Last zunächst mit einem Spannungs- und sodann mit einem Strompuls zu beaufschlagen, um z.B. Durchschläge in zu prüfenden Systemen simulieren zu können. Durch Verwendung von Funkenstrecken nach der Erfindung sind die Umschaltbedingungen von einem Spannungs- auf einen Strompuls in einfacher Weise kontrolliert veränderbar und zwar durch die Wahl des Absolutdruckes sowie insbesondere bei einem Generator mit zwei Funkenstrecken durch die Voreinstellung des Abstandes der Pole der später zündenden Funkenstrecke.

Es sei hier lediglich noch erwähnt, dass selbstverständlich auch ein Generator mit mehr als zwei Funkenstrecken durch eine entsprechende Erweiterung der Schaltung gemäss Fig. 3 aufgebaut werden könnte.

## Ansprüche

1. EMP-Generator mit mindestens einer in einem Gehäuse (20) angeordneten Funkenstrecke mit zwei annähernd kugelförmigen Polen (17, 18), wobei ein Innenraum (19) des Gehäuses (20) über eine erste Öffnung (21) und eine daran angeschlossene Druckluftleitung (7) unter einen Überdruck gegenüber seiner Umgebung setzbar ist, und in den Innenraum (19) des Gehäuses (20) hinein ein zu diesem Innenraum hin abgeschlossener Faltenbalg (28) ragt, an welchem einer der Pole (18) der Funkenstrecke befestigt ist, dadurch gekennzeichnet,

– dass der Innenraum des Faltenbalges (28) mit einer zweiten Druckluftleitung (8) in Verbindung steht,

– dass der Innenraum des Faltenbalgs (28) durch die zweite Druckluftleitung (8) unter einen vom vorgenannten Überdruck im Innenraum des Gehäuses (20) abweichenden, jedoch annähernd gleich grossen Überdruck setzbar ist,

– dass das Gehäuse (20) eine zweite Öffnung (23) aufweist, an die eine dritte Druckluftleitung (9) angeschlossen ist und

– dass die erste (21) und die zweite Öffnung (23) des Gehäuses (20) einander gegenüberliegend im Bereich der beiden Pole (17, 18) der Funkenstrecke angeordnet sind.

2. EMP-Generator nach Anspruch 1, weiter gekennzeichnet durch mindestens eines oder mehrere der folgenden Merkmale :

– Der Innenraum (19) des Gehäuses (29) sowie des Faltenbalges (28) ist unter einen Überdruck von bis zu $8 \cdot 10^5$ Pa setzbar ;

– das Gehäuse (20), sein Innenraum (19) sowie der Faltenbalg (28) weisen eine zylindrische Form auf ;

– bei übereinstimmendem Druck im Innenraum des Gehäuses (20) sowie im Innenraum des Faltenbalgs (28) ist die Funkenstrecke geschlossen, d.h. die Pole (17, 18) sind in Berührungskontakt miteinander ;

– bei einem höheren Druck im Innenraum (19) des Gehäuses (20) als im Innenraum des Faltenbalgs (28) ist letzterer gegenüber dem vorgenannten Zustand mit übereinstimmendem Druck hinsichtlich seiner Länge verkürzt und die Funkenstrecke offen, d.h. die Pole (17, 18) sind nicht in Berührungskontakt miteinander ;

– die Form der Form der Pole (17, 18) weicht auf ihren einander zugewandten Seiten von der sphärischen Form ab und ist vorzugsweise so ausgebildet, dass sich auf den genannten Seiten auf ihrer Oberfläche eine entlang dieser Oberfläche konstante elektrische Feldstärke einstellt, wenn eine Spannung zwischen ihnen angelegt ist ;

– die Pole (17, 18) sind jeweils mit ersten und zweiten Anschlusskontakten (26, 27) an den Aussenseiten des Gehäuses (20) elektrisch verbunden ;

– in der Verbindungsleitung der Pole (17, 18) mit den zweiten Anschlusskontakten (30, 31) ist jeweils mindestens ein ohm'scher Widerstand (5, 29) vorzugsweise jedoch eine Reihe solcher Widerstände angeordnet ;

– die Widerstände (5, 29) sind im Material des Gehäuses (20) eingebettet ;

– die ersten Anschlusskontakte (26, 27) sind auf einander gegenüberliegenden Seiten des Gehäuses (20) angeordnet, vorzugsweise auf einer gemeinsamen Achse mit derjenigen des Faltenbalges (28) und der Funkenstrecke ;

– das Material des Gehäuses ist ein elektrischer Isolierstoff ;

– der Durchmesser der Pole (17, 18) beträgt etwa 8 mm, ihr maximaler Abstand ist auf 20 mm einstellbar, alle übrigen Dimensionen sind so klein wie aus Stabilitätsgründen möglich gehalten.

3. EMP-Generator nach einem der Ansprüche 1 und 2, weiter gekennzeichnet durch folgende Merkmale :

– Mindestens zwei der Druckluftleitungen (7,8) sind über steuerbare Ventile (10, 11) an eine gemeinsame Druckluftleitung (13) angeschlossen ;

– für die Steuerung der Ventile (10, 11, 12) ist eine hydraulische Ablaufsteuerung vorgesehen ;

– die Ablaufsteuerung (14) erhält ihr Startsignal über eine Schlauchleitung (15) an deren freiem Ende ein von Hand bedienbarer Druckerzeuger vorgesehen ist.

4. EMP-Generator mit mindestens zwei mit mehreren Kondensatoren (42-45) in Reihe geschalteten Funkenstrecken nach Anspruch 1 (40, 41) und einem über mehrere Widerstände (46-49) mit der genannten Reihenschaltung verbundenen Netzgerät, gekennzeichnet durch folgende Merkmale :

– In der Reihenschaltung sind ausgehend von einem auf ein Referenzpotential geschalteten Anschlusspunkt mindestens ein Kondensator (42), eine erste Funkenstrecke (40), ein zweiter Kondensator (43), ein dritter Kondensator (44), eine zweite Funkenstrecke (41) sowie ein vierter Kondensator (45) in der genannten Reihenfolge in Reihe geschaltet ;

– der Potentialwert des Referenzpotentials ist, vorzugsweise symmetrisch, zwischen den Potentialwerten der beiden Klemmen des Netzgerätes und weiter vorzugsweise gleich dem Erdpotential gewählt,

– ein Anschlusspunkt zwischen dem ersten Kondensator (42) und der ersten Funkenstrecke (40) ist über einen ersten Widerstand (46) an eine der Klemmen des Netzgerätes angeschlossen ;

– ein Anschlusspunkt zwischen der ersten Funkenstrecke (40) und dem zweiten Kondensator (43) ist über einen zweiten Widerstand (48) an die andere der Klemmen des Netzgerätes angeschlossen ;

– ein Anschlusspunkt zwischen dem zweiten (43) und dem dritten Kondensator (44) ist, vorzugsweise über einen Entkopplungswiderstand (52, 53), mit dem Referenzpotential verbunden ;

– ein Anschlusspunkt zwischen dem dritten Kondensator (44) und der zweiten Funkenstrecke (41) ist über einen dritten Widerstand (47) mit der erstgenannten der Klemmen des Netzgerätes verbunden ;

– ein Anschlusspunkt zwischen der zweiten Funkenstrecke (41) und dem vierten Kondensator (45) ist über einen vierten Widerstand (49) mit der zweitgenannten Klemme des Netzgerätes verbunden.

5. EMP-Generator nach Anspruch 4, weiter gekennzeichnet durch eines oder mehrere der folgenden Merkmale :

– Die Spannung der Klemmen des Netzgerätes ist zu ± 25 kV bzw.-25 kV relativ zum Referenzpotential gewählt ;

– die Kapazitäten sämtlicher Kondensatoren (42-45) sind gleich gross ;

– die durch die Kapazität eines Kondensators (42, 43, 44, 46) und den Wert des Entkopplungswiderstands (52, 53) von vorzugsweise 1 MΩ bestimmte Zeitkonstante ist wesentlich grösser als die Entladezeitkonstante des gesamten Impulskreises ist ;

– die Widerstände (46-49) sind durch eine Reihenschaltung mehrerer Einzelwiderstände gebildet ;

– der Widerstandswert der Widerstände (46, 49) beträgt ca. 100 kΩ ;

– das Netzgerät liefert im Falle eines Kurzschlusses zwischen seinen Klemmen einen auf einen geringen Wert von vorzugsweise lediglich wenigen mA geregelten Kurzschlussstrom.

6. EMP-Generator nach einem der Ansprüche 4 oder 5, weiter gekennzeichnet durch folgendes Merkmal :

   – Für die Funkenstrecken (40, 41) sind Funkenstrecken von der Art verwendet, wie sie in den Ansprüche 1 und 2 gekennzeichnet sind.

7. EMP-Generator nach einem der Ansprüche 4 bis 6, weiter gekennzeichnet durch eines oder mehrere der folgenden Merkmale :

   – Für die Kondensatoren (42-45) sind Scheibenkondensatoren mit Anschlussklemmen auf ihren gegenüberliegenden Seitenflächen verwendet ;

   – die Kondensatoren sind mit den Funkenstrecken (40, 41) räumlich auf einer Achse angeordnet ;

   – der gegenseitige Abstand der genannten Elemente (40-45) auf der Achse ist so klein gewählt, wie deren Bauformen es zulassen ;

   – insbesondere sind die Funkenstrecken und Kondensatoren (40-45) mit derart ausgebildeten Anschlussklemmen versehen, dass sie unmittelbar aufeinander aufsteckbar sind ;

   – die Funkenstrecken (40, 41) sind mit den Kondensatoren (42-45) in einer räumlichen Baueinheit zusammengefasst.

8. EMP-Generator nach einem der Ansprüche 4 bis 6, weiter gekennzeichnet durch eines oder mehrere der folgenden Merkmale :

   – Die Funkenstrecken (40, 41) sind, getrennt von den Kondensatoren (42-45), zu einer räumlichen Baueinheit zusammengefasst ;

   – die Kondensatoren (42-45) sind ebenfalls zu einer separaten räumlichen Baueinheit zusammengefasst ;

   – beide Baueinheiten sind mit derart ausgebildeten Anschlusskontakten versehen, dass sie aufeinander aufsteckbar sind.

9. EMP-Generator nach einem der Ansprüche 4 bis 8, weiter gekennzeichnet durch eines oder mehrere der folgenden Merkmale :

   – Das Netzgerät ist als ein von den Funkenstrecken (40, 41) und den Kondensatoren (42-45) räumlich getrenntes, eigenständiges Gerät ausgebildet ;

   – die Klemmen des Netzgerätes sind über Kabel mit den zweiten Anschlusskontakten (30, 31) an den Funkenstrecken verbunden.

## Claims

1. EMP generator having at least one spark gap with approximately spherical poles (17, 18) arranged in a housing (20), an internal space (19) of the housing (20) being capable of being placed under excess pressure compared with its environment via a first opening (21) and a compressed-air line (7) connected thereto, and a folded bellows (28) projecting into the internal space (19) of the housing (20), which bellows is closed off with respect to this internal space and to which bellows one of the poles (18) of the spark gap is attached, characterized

   – in that the internal space of the folded bellows (28) is connected to a second compressed-air line (8) ;

   – in that the internal space of the folded bellows (28) can be placed via the second compressed-air line (8) under an excess pressure which deviates from the aforementioned excess pressure in the internal space of the housing (20) but is approximately of the same magnitude,

   – in that the housing (20) exhibits a second opening (23) to which a third compressed-air line (9) is connected ;

   – in that the first (21) and the second opening (23) of the housing (20) are arranged opposite to one another in the area of the two poles (17, 18) of the spark gap.

2. EMP generator according to Claim 1, furthermore comprising at least one or several of the following features :

   – the internal space (19) of the housing (29) and of the folded bellows (28) can be placed under an excess pressure of up to $8.10^5$ Pa ;

   – the housing (20), its internal space (19) and the folded bellows (28) exhibit a cylindrical shape ;

   – when the pressure in the internal space of the housing (20) corresponds to that in the internal space of the folded bellows (28), the spark gap is closed, that is to say the poles (17, 18) are in direct contact with one another ;

   – when the pressure in the internal space (19) of the housing (20) is higher than in the internal space of the folded bellows (28), the latter is shortened with respect to its length, compared with the aforementioned state when the pressure is in correspondence, and the spark gap is open, that is to say the poles (17, 18) are not in direct contact with one another ;

   – the form of the shape of the poles (17, 18) deviates from the spherical shape on their sides facing one another and is advantageously constructed in such a manner that an electrical field strength which is constant along this surface occurs on its surface on the said sides when a voltage is applied between them ;

   – the poles (17, 18) are in each case electrically connected to the first and second connecting contacts (26, 27) on the outsides of the housing (20);

   – at least one ohmic resistance (5, 29) but preferably a series of such resistances, is in each case arranged in the connecting line of the poles (17, 18) to the second connecting contacts (30, 31) ;

   – the resistances (5, 29) are embedded in the material of the housing (20) ;

   – the first connecting contacts (26, 27) are arranged on opposite sides of the housing (20), preferably on a common axis with that of the folded bellows (28) and of the spark gap ;
– the material of the housing is an electric insulating material ;
– the diameter of the poles (17, 18) is about 8 mm, their maximum spacing can be adjusted to 20 mm, all other dimensions are kept as small as possible for reasons of rigidity.

3. EMP generator according to one of Claims 1 and 2, furthermore comprising the following features:
– at least two of the compressed-air lines (7, 8) are connected via controllable valves (10, 11) to a common compressed-air line (13) ;
– an hydraulic sequence control system is provided for controlling the valves (10, 11, 12) ;
– the sequence control system (14) receives its starting signal via a hose line (15) at the free end of which a manually operable pressure generator is provided.

4. EMP generator having at least two spark gaps according to Claim 1 (40, 41) connected in series with several capacitors (42-45) and a power supply connected to the said series circuit via several resistors (46-49), comprising the following features :
– in the series circuit, starting from a connecting point connected to a reference potential, at least one capacitor (42), a first spark gap (40), a second capacitor (43), a third capacitor (44), a second spark gap (41) and a fourth capacitor (45) are connected in series in the above order ;
– the potential value of the reference potential is preferably symmetrically selected between the potential values of the two terminals of the power supply and furthermore advantageously equal to the ground potential ;
– a connecting point between the first capacitor (42) and the first spark gap (40) is connected via a first resistor (46) to one of the terminals of the power supply ;
– a connecting point between the first spark gap (40) and the second capacitor (43) is connected via a second resistor (48) to the other one of the terminals of the power supply ;
– a connecting point between the second (43) and the third capacitor (44) is connected to the reference potential, preferably via a decoupling resistor (52, 53) ;
– a connecting point between the third capacitor (44) and the second spark gap (41) is connected via a third resistor (47) to the first-mentioned terminal of the power supply ;
– a connecting point between the second spark gap (41) and the fourth capacitor (45) is connected via a fourth resistor (49) to the second-mentioned terminal of the power supply.

5. EMP generator according to Claim 4, furthermore comprising one or several of the following features :

– the voltage of the terminals of the power supply is selected as ± 25 kV or – 25 kV relative to the reference potential ;
– the capacitances of all capacitors (42-45) are of equal magnitude ;
– the time constant determined by the capacitance of a capacitor (42, 43, 44, 46) and the value of the decoupling resistor (52, 53) of preferably 1 MΩ is much greater than the discharge time constant of the entire pulse circuit ;
– the resistors (46-49) are formed by a series connection of several individual resistors ;
– the resistance value of the resistors (46, 49) is approximately 100 kΩ ;
– the power supply supplies in the case of a short circuit between its terminals a short-circuit current regulated to a low value of preferably only a few mA.

6. EMP generator according to one of Claims 4 or 5, furthermore comprising the following feature :
– spark gaps of the type characterized in Claims 1 and 2 are used for the spark gap (40, 41).

7. EMP generator according to one of Claims 4 to 6, furthermore comprising one or several of the following features :
– disc capacitors with connecting terminals on their opposite side faces are used for the capacitors (42-45) ;
– the capacitors are arranged spatially on one axis with the spark gaps (40, 41) ;
– the mutual spacing of the said elements (40-45) on the axis is selected to be as small as is permitted by their constructional shapes ;
– in particular, the spark gaps and capacitors (40-45) are provided with connecting terminals which are constructed in such a manner that they can be plugged directly onto one another ;
– the spark gaps (40, 41) are combined with the capacitors (42-45) in one spatial constructional unit.

8. EMP generator according to one of Claims 4 to 6, furthermore comprising one or several of the following features :
– the spark gaps (40, 41) are combined to form one spatial constructional unit separated from the capacitors (42-45) ;
– the capacitors (42-45) are also combined to form a separate spatial constructional unit ;
– the two constructional units are provided with connecting contacts constructed in such a manner that they can be plugged onto one another.

9. EMP generator according to one of Claims 4 to 8, furthermore comprising one or several of the following features :
– the power supply is constructed as an independent device spatially separated from the spark gaps (40, 41) and the capacitors (42-45) ;
– the terminals of the power supply are connected via cables to the second connecting contacts (30, 31) at the spark gaps.

## Revendications

1. Générateur d'impulsions électromagnétiques comportant au moins un éclateur situé dans un boîtier (20), qui présente deux pôles approximativement sphériques (17, 18) et dans lequel un espace intérieur (19) du boîtier (20) peut être pressurisé par rapport à son environnement par l'intermédiaire d'une première ouverture (21) et d'une conduite d'air comprimé (7) qui y est raccordée et un soufflet (28) auquel est fixé l'un des pôles (18) de l'éclateur et qui est fermé vers l'espace intérieur (19) du boîtier (20), s'étend dans cet espace intérieur (19), caractérisé en ce que :

l'espace intérieur du soufflet (28) communique avec une deuxième conduite d'air comprimé (8) ;
la deuxième conduite d'air comprimé (8) permet d'établir, dans l'espace intérieur du soufflet (28), une surpression différente de la surpression précitée régnant dans l'espace intérieur du boîtier (20), mais approximativement de même valeur ;
le boîtier (20) présente une deuxième ouverture (23) à laquelle est raccordée une troisième conduite d'air comprimé (9), et
la première (21) et la deuxième ouverture (23) du boîtier (20) sont disposées l'une en face de l'autre dans la zone des deux pôles (17, 18) de l'éclateur.

2. Générateur d'impulsions électromagnétiques suivant la revendication 1, caractérisé, en outre, par au moins une ou plusieurs des caractéristiques suivantes :

dans l'espace intérieur (19) du boîtier (20) et le soufflet (28) peut être établie une surpression pouvant atteindre $8.10^5$ Pa ;
Le boîtier (20), son espace intérieur (19) et le soufflet (28) sont de forme cylindrique ;
lorsque les pressions dans l'espace intérieur du boîtier (20) et dans l'espace intérieur du soufflet (28) correspondant, l'éclateur est fermé, c'est-à-dire que les pôles (17, 18) sont en contact l'un avec l'autre ;
dans le cas où la pression dans l'espace intérieur (19) du boîtier (20) est supérieure à celle régnant dans l'espace intérieur du soufflet (28), ce dernier est raccourci dans le sens longitudinal par rapport à son état précédent où les pressions correspondaient, et l'éclateur est ouvert, c'est-à-dire que les pôles (17, 18) ne sont pas en contact l'un avec l'autre ;
la forme des pôles (17, 18) s'écarte de la forme sphérique au niveau de leurs côtés orientés l'un vers l'autre et est, de préférence telle, qu'au niveau de la surface de ces côtés précités, une intensité de champ électrique constante s'établit sur cette surface lorsqu'une tension est appliquée entre les pôles ;
les pôles (17, 18) sont chacun connectés électriquement par des premiers et seconds contacts de connexion (26, 27) au côté extérieur du boîtier (20) ;
dans la ligne de connexion des pôles (17, 18) aux seconds contacts de connexion (30, 31) est chaque fois prévue au moins une résistance ohmique (5, 29), mais de préférence une série de telles résistances ;
les résistances (5, 29) sont noyées dans la matière du boîtier (20) ;
les premiers contacts de connexion (26, 27) sont disposés sur des côtés opposés du boîtier (20), de préférence sur un axe commun avec celui du soufflet (28) et de l'éclateur ;
la matière du boîtier est une matière isolante électrique ;
le diamètre des pôles (17, 18) est d'environ 8 mm, leur écartement maximal peut être réglé sur 20 mm, toutes les autres dimensions étant maintenues aussi petites que possible eu égard à la stabilité.

3. Générateur d'impulsions électromagnétiques suivant l'une quelconque des revendications 1 et 2, caractérisé, en outre, par les particularités suivantes :

au moins deux des conduites d'air comprimé (7, 8) sont raccordées par des valves pouvant être commandées (10, 11) à une conduite d'air comprimé commune (13) ;
pour la commande des valves (10, 11, 12), une commande séquentielle hydraulique est prévue ;
la commande séquentielle (14) reçoit son signal de démarrage par l'intermédiaire d'un tuyau souple (15) à l'extrémité libre de laquelle est prévu un générateur de pression à actionnement manuel.

4. Générateur d'impulsions électromagnétiques comprenant au moins deux éclateurs (40, 41) suivant la revendication 1, montés en série avec plusieurs condensateurs (42 à 45) et un appareil d'alimentation connecté audit montage en série par l'intermédiaire de plusieurs résistances (46 à 49), caractérisé par les particularités suivantes :

dans le montage en série sont connectés, dans l'ordre, à partir d'un point de connexion connecté à un potentiel de référence, au moins un condensateur (42), un premier éclateur (40), un deuxième condensateur (43), un troisième condensateur (44), un second éclateur (41), ainsi qu'un quatrième condensateur (45) ;
la valeur de potentiel du potentiel de référence est, de préférence, choisie symétriquement entre les valeurs de potentiel des deux bornes de l'appareil d'alimentation et, en outre, de préférence égale au potentiel de la terre ;
un point de jonction entre le premier condensateur (42) et le premier éclateur (40) est connecté, par l'intermédiaire d'une première résistance (46), à l'une des bornes de l'appareil d'alimentation ;

un point de jonction entre le premier éclateur (40) et le deuxième condensateur (43) est connecté, par l'intermédiaire d'une deuxième résistance (48), à l'autre des bornes de l'appareil d'alimentation ;

un point de jonction entre le deuxième (43) et le troisième condensateur (44) est connecté, de préférence par l'intermédiaire d'une résistance de découplage (52, 53), au potentiel de référence ;

un point de jonction entre le troisième condensateur (44) et le second éclateur (41) est connecté, par l'intermédiaire d'une troisième résistance (47), à la première citée des bornes de l'appareil d'alimentation ;

un point de jonction entre le second éclateur (41) et le quatrième condensateur (45) est connecté, par l'intermédiaire d'une quatrième résistance (49), à la seconde citée des bornes de l'appareil d'alimentation.

5. Générateur d'impulsions électromagnétiques suivant la revendication 4, caractérisé, en outre, par une ou plusieurs des particularités suivantes :

la tension des bornes de l'appareil d'alimentation est choisie égale à + 25 kV ou à – 25 kV par rapport au potentiel de référence ;

les capacités de tous les condensateurs (42 à 45) sont les mêmes ;

la constante de temps, déterminée par la capacité d'un condensateur (42, 43, 44, 46), et la valeur de la résistance de découplage (52, 53), qui est de préférence de 1 MΩ, est sensiblement plus grande que la constante de temps de décharge de l'ensemble du circuit d'impulsions ;

les résistances (46 à 49) sont formées par un montage en série de plusieurs résistances individuelles ;

la valeur de résistance des résistances (46, 49) est d'environ 100 kΩ ;

l'appareil d'alimentation fournit, dans le cas d'un court-circuit entre ses bornes, un courant de court-circuit réglé à une valeur faible qui n'atteint, de préférence, que quelques mA.

6. Générateur d'impulsions électromagnétiques suivant la revendication 4 ou 5, caractérisé, en outre, par la particularité suivante :

pour les éclateurs (40, 41), on utilise des éclateurs du type caractérisé dans les revendications 1 et 2.

7. Générateur d'impulsions électromagnétiques suivant l'une quelconque des revendications 4 a 6, caractérisé, en outre, par une ou plusieurs des particularités suivantes :

pour les condensateurs (42 à 45), on utilise des condensateurs en forme de disque présentant des bornes de connexion sur leurs faces latérales opposées ;

les condensateurs sont disposés dans l'espace sur le même axe que les éclateurs (40, 41) ;

l'espacement mutuel des éléments précités (40 à 45), le long de l'axe, est choisi aussi petit que le permet leur configuration ;

en particulier, les éclateurs et condensateurs (40 à 45) sont pourvus de bornes de connexion d'une configuration telle qu'ils peuvent être enfichés directement l'un dans l'autre ;

les éclateurs (40, 41) sont assemblés en une unité structurelle avec les condensateurs (42 à 45).

8. Générateur d'impulsions électromagnétiques suivant l'une quelconque des revendications 4 à 6, caractérisé, en outre, par une ou plusieurs des particularités suivantes :

les éclateurs (40, 41) sont assemblés en une unité structurelle, séparément des condensateurs (42 à 45) ;

les condensateurs (42 à 45) sont également assemblés en une unité structurelle séparée ;

les deux unités structurelles sont pourvues de contacts de connexion tels qu'ils permettent leur enfichage mutuel.

9. Générateur d'impulsions électromagnétiques suivant l'une quelconque des revendications 4 à 8, caractérisé, en outre, par une ou plusieurs des particularités suivantes :

l'appareil d'alimentation a la forme d'un appareil indépendant, séparé spatialement des éclateurs (40, 41) et des condensateurs (42 à 45) ;

les bornes de l'appareil d'alimentation sont connectées par câble aux seconds contacts de connexion (30, 31) des éclateurs.

FIG. 1

FIG. 2

FIG. 3

FIG. 4

FIG. 5

FIG. 6

FIG. 7